# FASCICULE DE BREVET EUROPEEN

(11) **EP 1 512 114 B1**
(45) Date de publication et mention de la délivrance du brevet: **28.12.2005**
(21) Numéro de dépôt: 03749916.7
(22) Date de dépôt: 02.05.2003
(51) Int. Cl.: G06K 9/20

(54) **PROCEDE DE FABRICATION DE CAPTEUR D'EMPREINTE DIGITALE ET CAPTEUR CORRESPONDANT**
VERFAHREN ZUR HERSTELLUNG EINES DIGITALEN FINGERABDRUCKSENSORS UND ENTSPRECHENDER SENSOR
METHOD OF PRODUCING A DIGITAL FINGERPRINT SENSOR AND THE CORRESPONDING SENSOR

(30) Priorité: 07.05.2002 FR 0205732
(43) Date de publication de la demande: 09.03.2005
(73) Titulaire: Atmel Grenoble, 38120 Saint-Egrève (FR)
(72) Inventeur: BOLIS, Sébastien, F-94117 Arcueil Cedex (FR); ROMAN, Cécile, F-94117 Arcueil Cedex (FR)
(74) Mandataire: Guérin, Michel
(86) Numéro de dépôt international: PCT/FR2003/001378
(87) Numéro de publication internationale: WO 2003/096265

(56) Documents cités:
- EP-A- 0 789 334
- EP-A- 1 136 936
- WO-A-02/069386
- JP-A- 61 032 535

## Description

L'invention concerne les capteurs d'empreinte digitales, et plus particulièrement un procédé de fabrication qui minimise les coûts de production et qui facilite l'usage du capteur ainsi que la protection du capteur contre les agressions extérieures.

Un capteur d'empreinte digitale est réalisé à partir d'un circuit intégré, en principe à base de silicium, comprenant notamment une matrice de points sensibles permettant d'établir une représentation de l'empreinte d'un doigt posé directement sur la surface de la matrice. La détection de l'empreinte peut être optique ou capacitive ou thermique ou piézoélectrique.

Certains capteurs fonctionnent en présence d'un doigt posé statiquement sur la surface d'un capteur dont la matrice active de détection, rectangulaire ou carrée, a une surface correspondant à la surface d'empreinte à détecter ; d'autres capteurs fonctionnent par glissement du doigt sur un capteur dont la matrice de détection, de surface beaucoup plus petite que l'empreinte à détecter, est une barrette allongée fine.

Dans les deux cas, mais surtout dans le cas d'un fonctionnement par glissement du doigt, le circuit intégré doit être protégé par des couches résistantes à l'usure. Ces couches dépendent du type de capteur (par exemple s'il s'agissait d'un capteur optique il est évident que les couches de protection éventuelles devraient être protégées par des couches transparentes). On a proposé des vernis de protection, ou encore des dépôts minéraux tels que des dépôts d'oxyde de silicium. D'autre part, la puce de circuit intégré formant le coeur du capteur doit être reliée électriquement à l'extérieur (notamment à des sources d'alimentation, des circuits de commande et des circuits d'exploitation des signaux électriques qui représentent l'empreinte digitale). Etant donné que le doigt doit être posé (ou doit glisser) sur la surface sensible du capteur, cette surface doit rester accessible. C'est pourquoi, pour ces capteurs on adopte une solution de liaison électrique traditionnelle par des fils souples soudés reliant des plots de contact de la face avant (face active) de la puce de circuit intégré, à des plots de contact situés sur une surface sur laquelle la puce est reportée. Dans les applications de circuit intégré autres que des capteurs (par exemple des microprocesseurs, des mémoires, etc.), ces fils sont traditionnellement protégés par une couche de protection épaisse, déposée ou surmoulée, qui enferme la puce et ses fils.

Selon l'invention, on propose un procédé de fabrication d'un capteur d'empreinte digitale dans lequel on effectue les étapes suivantes : fabriquer une puce de capteur, reporter cette puce sur un substrat, relier la puce au substrat par des fils soudés, placer l'ensemble de la puce et du substrat dans un moule, couler dans le moule une résine de protection recouvrant au moins en partie la puce et le substrat et enfermant totalement les fils, le moule ayant une forme telle qu'un bossage de résine, dépassant d'au moins 500 micromètres de haut une surface sensible de la puce, soit formé sur au moins un côté de la puce, ce bossage protégeant les fils soudés et formant un guide de positionnement pour le doigt dont on veut détecter l'empreinte afin que l'empreinte à détecter vienne en regard d'une surface sensible de la puce lorsque le doigt vient contre le bossage.

De préférence, un côté au moins de la puce sera dépourvu d'un tel bossage de guidage. Dans le cas d'une détection par glissement du doigt sur une puce en forme de barrette allongée perpendiculairement à la direction de glissement du doigt, deux côtés de la puce seront dépourvus d'un tel bossage de guidage : un bossage sera prévu soit sur un seul côté de la puce soit sur deux côtés opposés (se faisant face dans la direction d'allongement de la barrette), mais pas sur les deux autres côtés.

Dans le cas d'un capteur d'empreinte de type capacitif, le moule sera tel que la surface sensible de la puce ne sera pas recouverte de résine, et les bossages s'élèveront directement au-dessus de la surface de la puce, laissant libre la surface sensible de la puce.

Mais, avantageusement, dans le cas d'un capteur de type thermique ou piézoélectrique, on prévoira de recouvrir la surface sensible d'une fine couche de résine moulée protégeant cette surface (de préférence une couche uniforme d'environ 20 à 60 micromètres d'épaisseur) ; les bossages s'éleveront de quelques millimètres au-dessus de cette fine couche de résine.

La puce de circuit intégré ainsi encapsulée comprend donc dès sa fabrication un élément d'ergonomie (élément de guidage du doigt), de sorte que cette puce peut être installée directement dans des applications sans qu'il soit nécessaire de concevoir l'environnement de ces applications avec des éléments de guidage spécifiques. Par exemple, pour installer ce capteur sur un clavier d'ordinateur, il n'est pas nécessaire de redessiner le boîtier du clavier. Le capteur pourra être installé sur une surface plane de ce clavier.

Le substrat peut être rigide ou flexible. Il comportera des contacts électriques laissés libres (non recouverts de résine moulée), pour la connexion du capteur avec l'extérieur.

De préférence, l'encapsulation par moulage de résine se fera sur plusieurs puces simultanément, les capteurs individuels ainsi encapsulés étant détachés ultérieurement les uns des autres.

Dans le cas où une fine couche de résine moulée recouvre la surface active du capteur, on prévoit de préférence de mettre en place sur la face avant de la puce de circuit intégré, avant mise en place de la puce dans le moule, des entretoises de hauteur calibrée contre lesquelles vient s'appuyer le fond du moule, pour définir parfaitement l'épaisseur de résine qui recouvrira la surface active du capteur. Ces entretoises sont placées de préférence tout autour de cette surface active, de manière à ne pas gêner le fonctionnement de la détection d'empreinte. Elles peuvent consister en bossages de quelques dizaines de micromètres de haut, formés au cours de la fabrication de la puce proprement dite et par conséquent intégrés à la puce. Elles peuvent aussi être constituées par des billes ou cylindres de diamètre calibré, posées à la surface de la puce sur des zones préalablement revêtues de colle.

En résumé, on aboutit selon l'invention à un capteur d'empreinte digitale comportant une puce de capteur présentant une surface sensible, un substrat pourvu de connexions électriques et des fils soudés reliant la puce aux connexions électriques, caractérisé en ce qu'il comporte une résine de protection moulée recouvrant au moins en partie le substrat et la puce et enfermant complètement les fils soudés, et en ce que la résine forme, sur au moins un côté de la puce et sur au plus trois côtés, un bossage s'élevant d'au moins 500 micromètres au dessus de la surface sensible, ce bossage enfermant les fils soudés et constituant un guide pour un doigt dont on veut détecter l'empreinte. Pour un capteur agencé pour détecter une empreinte lors du glissement d'un doigt perpendiculairement à la direction d'allongement de la puce, celle-ci étant en forme de barrette, un bossage de résine est prévu sur deux côtés au plus de la puce, ces côtés étant les petits côtés.

D'autres caractéristiques et avantages de l'invention apparaîtront à la lecture de la description détaillée qui suit et qui est faite en référence aux dessins annexés dans lesquels :
- la figure 1 représente le capteur d'empreinte avant encapsulation ;
- la figure 2 représente en coupe le principe de l'encapsulation du capteur ;
- la figure 3 représente le capteur encapsulé, en perspective ;
- la figure 4 représente en perspective, vu de dessus et vu de dessous, une variante de réalisation du capteur ;
- la figure 5 représente en coupe une réalisation avec revêtement de la surface active du capteur par une fine couche de résine moulée.

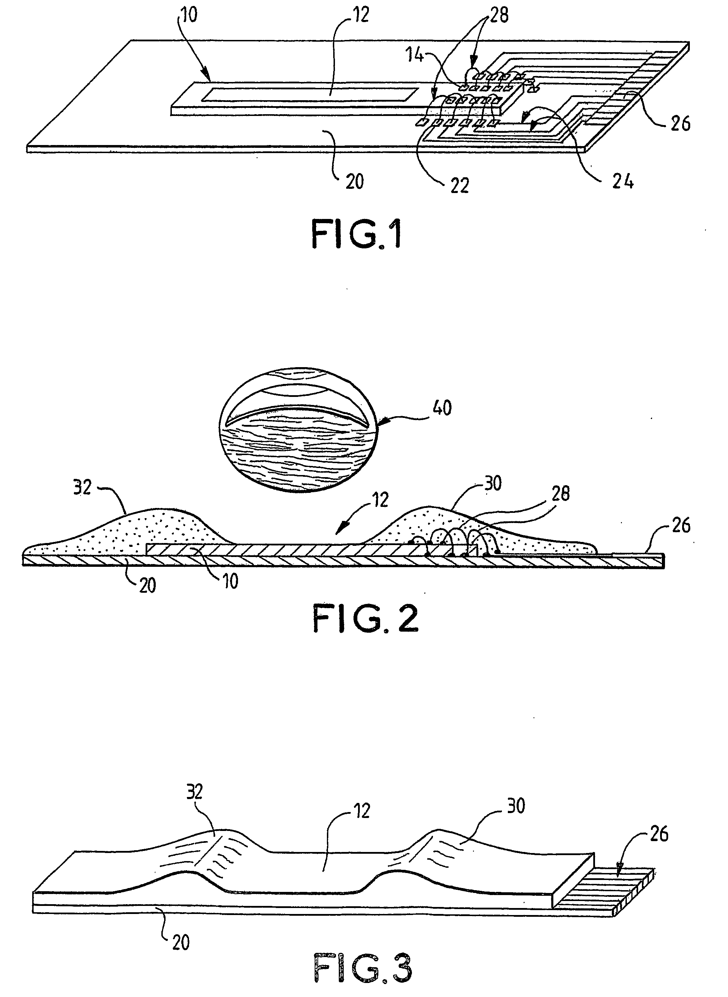

Sur la figure 1, on a représenté un exemple de capteur d'empreinte digitale réalisé à partir d'une puce de circuit intégré 10 en forme de barrette allongée (longueur beaucoup plus grande que la largeur) sur laquelle on devra faire glisser un doigt pour détecter successivement des portions d'image de doigt au fur et à mesure que le doigt glissera sur la surface de la puce. Le glissement du doigt se fait perpendiculairement ou à peu près perpendiculairement à la longueur de la barrette. La puce comprend une matrice de quelques lignes (5 à 10 lignes par exemple) de nombreux détecteurs élémentaires (une centaine à quelques centaines de détecteurs élémentaires par ligne par exemple) et chaque image comprend donc quelques lignes de nombreux points. Par corrélation des images partielles successivement obtenues au fur et à mesure du déplacement du doigt, on reconstruit une image globale de l'empreinte digitale qui a parcouru la surface du capteur. Le capteur peut être thermique (mesures de différences d'échanges de chaleur entre le doigt et un détecteur selon qu'une crête ou une vallée d'empreinte digitale est en regard d'un détecteur élémentaire). Il peut aussi être piézoélectrique (différence de pression exercée selon la présence d'une crête ou d'une vallée), ou capacitif (différence de capacité selon la présence d'une crête ou d'une vallée) ; il peut enfin être optique (différence d'intensité lumineuse réfléchie).

Dans l'exemple représenté, la puce allongée 10 comporte une zone active sensible 12 subissant l'influence du relief de l'empreinte digitale et constituée essentiellement par une matrice de plusieurs lignes de détecteurs élémentaires, et une zone périphérique comprenant d'une part des circuits associés à la matrice (alimentation, commande, recueil de signaux fournis par la matrice) et d'autre part des plots de contact conducteurs 14 servant à la connexion de la puce avec l'extérieur.

La puce est classiquement reportée sur un substrat 20 comportant lui-même des plots conducteurs correspondants 22, des connexions électriques 24 reliées à ces plots 22, et des plages de contact ou des broches 26 destinés à la connexion de l'ensemble puce+substrat avec des éléments extérieurs au capteur proprement dit (par exemple pour communiquer avec un ordinateur auquel on veut transférer, pour traitement et utilisation, les signaux électriques permettant de reconstituer l'image d'empreinte détectée).

La puce est reportée sur ce substrat 20 par sa face arrière, inactive ; la face avant, sensible, reste accessible pour le doigt. Le mode de connexion le plus traditionnel, à savoir par fils soudés (en anglais : « wire-bonding ») est de préférence utilisé pour relier les plots 14 de la puce aux pots 22 du substrat. Les fils soudés sont désignés par 28 sur la figure 1.

L'opération d'encapsulation postérieure au report de la puce 10 sur le substrat 20 consiste à placer l'ensemble de la puce de circuit intégré et du substrat dans un moule permettant d'injecter une résine de protection des parties fragiles de l'ensemble. Parmi ces parties fragiles, il y a bien entendu les fils soudés 28. La résine est liquide et est polymérisée dans le moule pour se solidifier. Il s'agit classiquement d'une résine bicomposant.

La forme du moule est adaptée pour que la résine solidifiée forme un ou plusieurs bossages relativement épais (en pratique l'épaisseur est supérieure à ce qui est strictement nécessaire pour la simple protection de la puce et de ses fils soudés 28) au-dessus de la surface sensible de la puce, sur au moins un côté de la puce. L'épaisseur des bossages est de préférence d'environ un millimètre mais pas plus au-dessus de la surface sur laquelle reposera le doigt en utilisation. C'est-à-dire que si la surface de la puce reste non recouverte de résine, les bossages dépassent d'environ un millimètre la surface supérieure de la puce, mais si la surface de la partie active de la puce est elle-même recouverte d'une fine couche de résine sur laquelle viendra s'appuyer le doigt, les bossages dépassent d'un millimètre au-dessus de cette couche.

La figure 2 représente, en coupe, la puce 10 et son substrat 20 encapsulés dans la résine présentant deux bossages, un de chaque côté de la puce allongée, sur les petits côtés. Dans cet exemple, tous les fils soudés 28 servant à la connexion de la puce avec le substrat sont situés sur un même petit côté de la puce allongée. Un bossage de résine 30 les recouvre et les protège. Ce bossage constitue l'élément principal de positionnement et de guidage du doigt dans son mouvement de glissement transversalement à la direction d'allongement de la barrette. Un deuxième bossage 32, facultatif, peut être formé par moulage sur l'autre petit côté de la barrette. Le doigt 40 vient alors se placer entre les deux bossages. La surface supérieure sensible de la puce 10 n'est pas recouverte de résine dans cette réalisation de la figure 2.

Dans le cas d'un capteur sur lequel le doigt glisse, on prévoit au maximum deux bossages. Dans le cas d'un capteur sur lequel le doigt reste statique, avec une puce carrée ou rectangulaire mais pas en forme de barrette, on peut prévoir jusqu'à trois bossages permettant de délimiter trois côtés de la surface active, le doigt pouvant s'appuyer sur deux ou trois de ces bossages.

Les plages de contact de connexion extérieure 26 ne sont pas recouvertes par la résine de moulage. Dans l'exemple représenté aux figures 1 et 2, ces plages sont sur la surface supérieure du substrat 20. Les plots 22 du substrat, les connexions 24 et les plages 26 sont réalisées en un film métallique recouvrant la surface du substrat, lequel est en matière plastique ou en céramique. Les plages 26 sont situées du côté supérieur du substrat (celui sur lequel la puce est reportée). Il est cependant possible aussi d'utiliser d'autres types de connexion, et en particulier les connexions par lames conductrices, connues sous l'appellation anglaise « beam-lead ». Il s'agit d'une grille conductrice rigide constituant en elle-même à la fois le substrat sur lequel est reporté la puce, les plots 22, les connexions 24 et les plages conductrices 26. Dans ce cas, on comprend que les plages conductrices 26 peuvent être accessibles par l'arrière du substrat plutôt que par l'avant. Dans d'autres réalisations encore les plages de connexion 26 peuvent être accessibles par l'arrière du substrat. C'est le cas par exemple si le substrat est un substrat multicouche comportant des conducteurs d'interconnexion aussi bien sur sa surface avant que sur sa surface arrière avec des vias conducteurs entre les deux.

La figure 3 représente en perspective un exemple de réalisation dans lequel les plages conductrices 26 sont constituées en forme de connecteur mâle. Pour la connexion du substrat avec l'extérieur un connecteur complémentaire peut être enfiché sur les plages 26 ou appliqué contre ces plages selon la configuration de celles-ci.

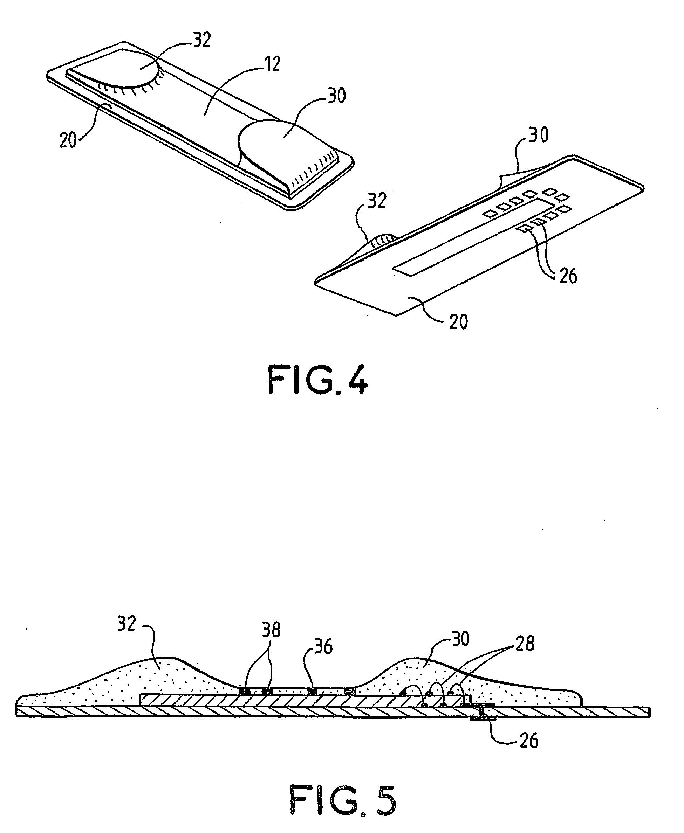

La figure 4 représente en perspective un autre exemple de réalisation dans lequel les plages de connexion 26 du substrat sont situées sur le dessous du substrat, ce dernier étant constitué par une structure multicouche. Sur la figure 4, on a représenté des bossages 30 et 32 de forme différente de celle de la figure 3 mais remplissant la même fonction de protection des fils soudés et de guidage du doigt.

Sur la figure 5, dans laquelle on a aussi prévu des plages de connexion 26 au-dessous du substrat 20, on a représenté en coupe une autre réalisation dans laquelle la résine 36 vient recouvrir, en couche mince de quelques dizaines de micromètres d'épaisseur, la surface active de la puce entre les bossages 30 et 32. Pour définir cette fine épaisseur, on prévoit de préférence des entretoises 38 à la surface de la puce, ces entretoises ayant l'épaisseur désirée. Le fond du moule vient s'appuyer contre les entretoises et la résine liquide peut être injectée dans l'intervalle qui subsiste ainsi entre la surface avant de la puce et le fond du moule. Cette réalisation est intéressante dans le cas d'un capteur thermique dont la surface de puce ne peut pas en pratique être recouverte d'une couche de passivation en silice comme ce serait le cas par exemple pour un capteur optique. Les entretoises 38 peuvent être réalisées de plusieurs façons. Elles sont placées non pas directement dans la zone active du capteur, mais dans une zone périphérique de la face avant de la puce. Dans un exemple, elles sont constituées par des billes ou des cylindres de verre de diamètre calibré, mis en place sur des points de colle préalablement déposée sur la périphérie de la zone active. Les billes peuvent être en verre. Les cylindres peuvent être des fragments de fibres de verre d'une dizaine à quelques dizaines de micromètres de diamètre. Dans un autre exemple, les entretoises sont intégrées à la surface de la puce par exemple sous forme de dépôts métalliques localisés. Ces dépôts peuvent être formés électrolytiquement.

La fabrication des capteurs se fait de préférence par moulage d'un lot de plusieurs capteurs sur un substrat commun. Les capteurs individuels, comprenant chacun une puce respective et pourvus chacun de leurs bossages et de leurs connexions, sont détachés les uns des autres après moulage. Un moulage sur un ruban continu de substrats attachés les uns aux autres est la solution préférée. Selon les applications, on peut prévoir qu'il y a plusieurs puces dans un même capteur, encapsulées en une même opération. La résine utilisée peut être une résine transparente, en particulier lorsque le capteur est optique et que la surface active est recouverte de résine.

## Revendications

1. Procédé de fabrication d'un capteur d'empreinte digitale dans lequel le capteur est agencé pour permettre une détection d'empreinte par glissement du doigt sur la surface active, et dans lequel on effectue les étapes suivantes : fabriquer une puce de capteur (10), la puce étant en forme de barrette allongée ayant deux petits côtés, reporter cette puce sur un substrat (20), relier la puce (10) au substrat (20) par des fils soudés (28) disposés sur un petit côté de la puce, placer l'ensemble de la puce et du substrat dans un moule, couler dans le moule une résine de protection recouvrant au moins partiellement le substrat et la puce et enfermant complètement les fils, le moule ayant une forme telle qu'un bossage (30) de résine, dépassant d'au moins 500 micromètres de haut une surface sensible de la puce, soit formé sur au moins un côté de la puce, ce bossage protégeant les fils soudés et formant un guide de positionnement pour le doigt dont on veut détecter l'empreinte afin que l'empreinte à détecter se déplace en regard d'une surface active sensible de la puce lorsque le doigt vient glisser contre le bossage.

2. Procédé selon la revendication 1, **caractérisé en ce que** les deux petits côtés de la puce sont pourvus d'un bossage de guidage, le moule étant conformé de manière que les deux autres côtés de la puce soient dépourvus de bossage.

3. Procédé selon l'une des revendications précédentes, **caractérisé en que** le moule est conformé de manière que la surface active de la puce soit recouverte d'une fine couche de résine moulée (36) protégeant cette surface.

4. Procédé selon la revendication 3, **caractérisé en ce que**, avant mise en place du substrat dans le moule, on place sur la face avant de la puce de circuit intégré, avant mise en place de la puce dans le moule, des entretoises (38) de hauteur calibrée contre lesquelles vient s'appuyer le fond du moule, pour définir parfaitement l'épaisseur de résine qui recouvrira la surface sensible du capteur.

5. Procédé selon l'une des revendications 3 et 4, **caractérisé en ce que** l'épaisseur des entretoises au-dessus de la surface sensible de la puce est d'une dizaine à quelques dizaines de micromètres.

6. Procédé selon l'une des revendications précédentes, **caractérisé en ce que** le bossage fait moins d'un millimètre de haut.

7. Capteur d'empreinte digitale comportant une puce de capteur en forme de barrette allongée ayant deux petits côtés et présentant une surface sensible (12), un substrat pourvu de connexions électriques (26) et des fils soudés (28) reliant un petit côté de la puce aux connexions électriques, les grands côtés étant dépourvus de fils soudés, **caractérisé en ce qu'**il comporte une résine de protection moulée recouvrant au moins en partie le substrat et la puce et enfermant complètement les fils soudés, et **en ce que** la résine forme, sur au moins un côté de la puce et sur au plus deux côtés, un bossage s'élevant d'au moins 500 micromètres au-dessus de la surface sensible, ce bossage enfermant les fils soudés et constituant un guide pour un doigt dont on veut détecter l'empreinte lors du glissement du doigt sur le capteur perpendiculairement à la direction d'allongement de la puce.

8. Capteur selon la revendication 7, **caractérisé en ce que** le bossage fait moins d'un millimètre de haut au dessus de la surface sensible.

## Patentansprüche

1. Verfahren zur Herstellung eines Fingerabdrucksensors, wobei der Sensor ausgelegt ist, um eine Abdruckerfassung durch Gleiten des Fingers auf der aktiven Fläche zu ermöglichen, und wobei die folgenden Schritte durchgeführt werden: Herstellen eines Sensorchips (10), wobei der Chip die Form einer länglichen Leiste mit zwei kleinen Seiten hat, Aufbringen dieses Chips auf ein Substrat (20), Verbinden des Chips (10) mit dem Substrat (20) über verschweißte Drähte (28), die auf einer kleinen Seite des Chips angeordnet sind, Anordnen der Einheit aus Chip und Substrat in einem Formwerkzeug, Gießen eines Schutzharzes, das das Substrat und den Chip zumindest teilweise bedeckt und die Drähte vollständig umschließt, in das Formwerkzeug, wobei das Formwerkzeug eine solche Form hat, dass ein Harzbuckel (30), der um mindestens 500 Mikrometer über einer empfindlichen Fläche des Chips hochsteht, auf mindestens einer Seite des Chips geformt wird, wobei dieser Buckel die geschweißten Drähte schützt und eine Positionierführung für den Finger bildet, dessen Abdruck erfasst werden soll, damit der zu erfassende Abdruck sich vor einer empfindlichen aktiven Fläche des Chips bewegt, wenn der Finger gegen den Buckel gleitet.

2. Verfahren nach Anspruch 1, **dadurch gekennzeichnet, dass** die beiden kleinen Seiten des Chips mit einem Führungsbuckel versehen sind, wobei das Formwerkzeug so ausgebildet ist, dass die beiden anderen Seiten des Chips keinen Buckel aufweisen.

3. Verfahren nach einem der vorhergehenden Ansprüche, **dadurch gekennzeichnet, dass** das Formwerkzeug so ausgebildet ist, dass die aktive Fläche des Chips mit einer dünnen geformten Harzschicht (36) bedeckt wird, die diese Fläche schützt.

4. Verfahren nach Anspruch 3, **dadurch gekennzeichnet, dass** vor dem Einsetzen des Substrats in das Formwerkzeug auf die Vorderseite des IC-Chips, vor dem Einsetzen des Chips in das Formwerkzeug, Stege (38) mit kalibrierter Höhe angeordnet werden, gegen die der Boden des Formwerkzeugs sich anlegt, um die Harzdicke perfekt zu definieren, die die empfindliche Fläche des Sensors bedecken wird.

5. Verfahren nach einem der Ansprüche 3 und 4, **dadurch gekennzeichnet, dass** die Dicke der Stege über der empfindlichen Fläche des Chips zehn bis einige zehn Mikrometer beträgt.

6. Verfahren nach einem der vorhergehenden Ansprüche, **dadurch gekennzeichnet, dass** der Buckel weniger als ein Millimeter hoch ist.

7. Fingerabdrucksensor, der einen Sensorchip in Form einer länglichen Leiste mit zwei kleinen Seiten und mit einer empfindlichen Fläche (12) und ein Substrat aufweist, das mit elektrischen Verbindungen (26) und den geschweißten Drähten (28) versehen ist, die eine kleine Seite des Chips mit den elektrischen Verbindungen verbinden, wobei die großen Seiten keine geschweißten Drähte aufweisen, **dadurch gekennzeichnet, dass** er ein geformtes Schutzharz aufweist, das zumindest zum Teil das Substrat und den Chip bedeckt und die geschweißten Drähte vollständig umschließt, und dass das Harz auf mindestens einer Seite des Chips und höchstens auf zwei Seiten einen Buckel bildet, der sich um mindestens 500 Mikrometer über der empfindlichen Fläche erhebt, wobei dieser Buckel die geschweißten Drähte umschließt und eine Führung für einen Finger bildet, dessen Abdruck beim Gleiten des Fingers über den Sensor lotrecht zur Ausdehnungsrichtung des Chips erfasst werden soll.

8. Sensor nach Anspruch 7, **dadurch gekennzeichnet, dass** der Buckel über der empfindlichen Fläche weniger als einen Millimeter hoch ist.

## Claims

1. Method of manufacturing a fingerprint sensor in which the sensor is designed to allow fingerprint detection by the finger sliding over the active surface, and in which the following steps are carried out: a sensor chip (10) is fabricated, the chip being in the form of an elongate strip having two short sides; this chip is mounted on a substrate (20); the chip (10) is connected to the substrate (20) by wire-bonding wires (28) placed on one short side of the chip; the chip/substrate assembly is placed in a mould; a protective resin is poured into the mould so as to at least partly cover the substrate and the chip and to completely encapsulate the wires, the mould having a shape such that a bump (30) of resin, projecting by at least 500 microns above a sensitive surface of the chip, is formed on at least one side of the chip, this bump protecting the wire-bonding wires and forming a positioning guide for the finger, the fingerprint of which it is desired to detect, so that the latter moves opposite a sensitive active surface of the chip when the finger slides against the bump.

2. Method according to Claim 1, **characterized in that** the two short sides of the chip are provided with a guiding bump, the mould being shaped so that the other two sides of the chip do not have a bump.

3. Method according to one of the preceding claims, **characterized in that** the mould is shaped so that the active surface of the chip is covered with a thin, moulded resin layer (36) that protects this surface.

4. Method according to Claim 3, **characterized in that**, before the substrate is placed in the mould, spacers (38) of calibrated height, against which the bottom of the mould will bear, are placed on the front face of the integrated-circuit chip, before the chip is placed in the mould, in order for the thickness of resin that will cover the sensitive surface of the sensor to be perfectly defined.

5. Method according to either of Claims 3 and 4, **characterized in that** the thickness of the spacers above the sensitive surface of the chip ranges from about 10 microns to several tens of microns.

6. Method according to one of the preceding claims, **characterized in that** the bump is less than one millimetre in height.

7. Fingerprint sensor comprising a sensor chip in the form of an elongate strip having two short sides and having a sensitive surface (12), a substrate provided with electrical connections (26) and wire-bonding wires (28) connecting a short side of the chip to the electrical connections, the long sides having no wire-bonding wires, **characterized in that** it includes a moulded protective resin at least partly covering the substrate and the chip and completely encapsulating the wire-bonding wires, and **in that** the resin forms, on at least one side of the chip and at most on two sides, a bump rising to at least 500 microns above the sensitive surface, this bump encapsulating the wire-bonding wires and constituting a guide for a finger, the fingerprint of which it is desired to detect when the finger is slid over the sensor perpendicular to the long direction of the chip.

8. Sensor according to Claim 7, **characterized in that** the bump is less than one millimetre above the height of the sensitive surface.
